# EUROPÄISCHE PATENTSCHRIFT

(11) **EP 2 119 009 B1**
(45) Veröffentlichungstag und Bekanntmachung des Hinweises auf die Patenterteilung: **26.05.2010**
(21) Anmeldenummer: 08708300.2
(22) Anmeldetag: 28.01.2008
(51) Int. Cl.: H03K 17/687, F02D 41/20

(54) **SCHALTUNGSANORDNUNG UND VERFAHREN ZUM BETREIBEN EINER INDUKTIVEN LAST**
CIRCUIT ARRANGEMENT AND METHOD FOR OPERATING AN INDUCTIVE LOAD
AGENCEMENT DE CIRCUIT ET PROCÉDÉ POUR FAIRE FONCTIONNER UNE CHARGE INDUCTIVE

(30) Priorität: 07.02.2007 DE 102007006179
(43) Veröffentlichungstag der Anmeldung: 18.11.2009
(73) Patentinhaber: Continental Automotive GmbH, 30165 Hannover (DE)
(72) Erfinder: BOLZ, Stephan, 93102 Pfatter (DE)
(86) Internationale Anmeldenummer: PCT/EP2008/050982
(87) Internationale Veröffentlichungsnummer: WO 2008/095818

(56) Entgegenhaltungen:
- WO-A-2006/134009
- DE-A1- 19 728 221
- JP-A- 2000 028 027
- JP-A- 2001 012 285
- JP-A- 2001 015 332
- US-A- 5 717 562

## Beschreibung

Die Erfindung betrifft eine Schaltungsanordnung zum Betreiben einer induktiven Last, insbesondere eines Magnetventils eines Kraftstoffeinspritzsystems einer Brennkraftmaschine.

Beim Betrieb einer induktiven Last ist es oftmals wünschenswert, einen durch die Last fließenden Strom, nachfolgend als Laststrom bezeichnet, möglichst rasch und präzise einstellen bzw. verändern zu können. Falls es sich bei der induktiven Last beispielsweise um ein Magnetventil eines Kraftstoffeinspritzsystems einer Brennkraftmaschine handelt, so kann durch ein rasches Einschalten, präzises Einstellen und rasches Ausschalten des Laststromes eine Verbesserung der Leistungseigenschaften der Brennkraftmaschine erreicht werden. Insbesondere die in letzter Zeit strenger gewordenen Abgasnormen für Brennkraftmaschinen in der Kraftfahrzeugindustrie erfordern im Falle der Verwendung von elektromagnetischen Einspritzventilen ein möglichst schnelles und verzögerungsfreies Ansprechen der betreffenden Einspritzventile.

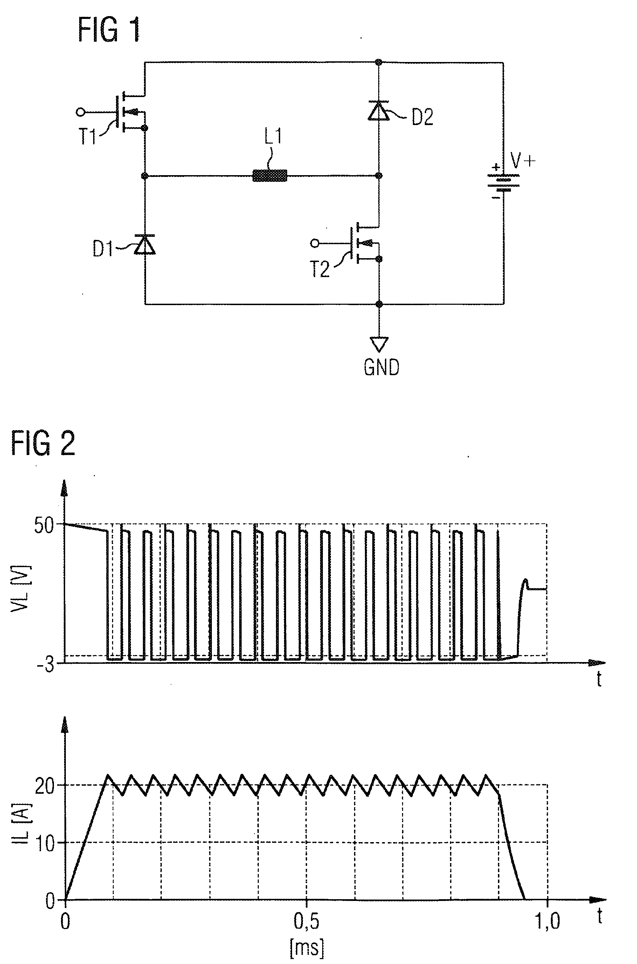

Zum besseren Verständnis der unten beschriebenen Erfindung sei eine beim Betrieb einer induktiven Last sich ergebende grundsätzliche Problematik zunächst anhand der Fig. 1 und 2 erläutert.

Fig. 1 zeigt eine Schaltungsanordnung zum Betreiben einer induktiven Last L1 durch Bestromung derselben aus einer Spannungsquelle (Betriebsspannung V+).

Bei der dargestellten Schaltungsanordnung kann die induktive Last L1 über zwei Schalttransistoren T1 und T2 in der dargestellten Weise mit der Betriebsspannung V+ verbunden werden. Ein schneller Stromaufbau beim Einschalten des Laststromes ist auf Grund des induktiven Charakters der Last L1 nur mit einer "erhöhten" Betriebsspannung V+ möglich. Dies soll bedeuten, dass der Wert der Betriebsspannung V+ nennenswert größer als ein Spannungswert ist, der im stationären Zustand (konstanter Laststrom) ausreichend wäre, einen in einer Bestromungsphase maximal gewünschten Laststrom durch die Last L1 zu treiben. Im Rahmen der unten beschriebenen Erfindung wird eine derartige erhöhte Betriebsspannung auch als "erste Betriebsspannung" oder "Boostspannung" bezeichnet werden.

Um nach dem Einschalten des Laststromes einen für die Bestromungsphase gewünschten Laststrom einzustellen, kann mit der dargestellten Schaltungsanordnung der Laststrom durch einen PWM-Betrieb (Puls-Weiten-Modulation) auf einen vorgegebenen Stromwert geregelt werden.

Eine Bestromungsphase, bei welcher zunächst der Laststrom eingeschaltet wird, dann auf einen gewünschten Laststrom eingestellt wird und schließlich wieder ausgeschaltet wird, kann mit der dargestellten Schaltungsanordnung wie folgt realisiert werden:

Zu Beginn des Einschaltvorganges werden die Transistoren T1 und T2 geschlossen. An der Last L1 liegt nun die Betriebsspannung V+ an und der Laststrom steigt schnell an. Fig. 2 zeigt die Verläufe einer an der Last L1 anliegenden Lastspannung VL sowie des durch die Last fließenden Laststromes IL in Abhängigkeit von der Zeit t. Der Laststrom IL wird durch eine nicht dargestellte Messeinrichtung gemessen, welche mit einer ebenfalls nicht dargestellten Steuereinrichtung zur Ansteuerung der Transistoren T1 und T2 verbunden ist. Bei Erreichen einer oberen Stromgrenze (oberer Stromsollwert) wird T1 ausgeschaltet und der Laststrom IL fließt nun weiter durch eine Freilaufdiode D1 und den Transistor T2, wobei er langsam sinkt. Erreicht der Laststrom IL nun eine untere Stromgrenze (unterer Stromsollwert), so wird T1 wieder eingeschaltet, woraufhin der Laststrom abermals ansteigt. Durch wiederholtes Ein- und Ausschalten von T1 (z. B. Zweipunktregelung) kann so der Laststrom während der Dauer der Bestromungsphase auf einem annähernd konstanten Wert gehalten werden. Zum Ende der Bestromungsphase werden die Transistoren T1 und T2 gleichzeitig ausgeschaltet und der Laststrom IL wird über die Freilaufdiode D1 und eine Rekuperationsdiode D2 in die Versorgung (Spannungsquelle) zurückgespeist.

Wie bereits erwähnt kann es sich bei der induktiven Last L1 beispielsweise um ein Magnetventil eines Kraftstoffeinspritzsystems handeln, beispielsweise für ein Hochdruck-Direkteinspritzsystem für Diesel oder Benzin (Pumpe-Düse, HPDI etc.). Andere Anwendungen könnten beispielsweise sein: 3-Phasen-Frequenzumrichter zum Betrieb von Elektromotoren oder Generatoren mit elektronischer Kommutierung (ISG), bidirektionaler DC/DC-Wandler (z. B. 14 V/42 V, ISG), elektromagnetischer Ventiltrieb (IVT) etc.

Insbesondere für Betriebsspannungen V+ von weniger als 200 V können vorteilhaft MOS-Leistungstransistoren als Schalttransistoren T1 und T2 verwendet werden, aus Kostengründen bevorzugt N-Kanal-Typen.

Die in Fig. 1 dargestellte Schaltungsanordnung besitzt jedoch eine Reihe von Nachteilen wie z. B. einen vergleichsweise schlechten Wirkungsgrad, da die erhöhte Betriebsspannung V+ in der Praxis oftmals zunächst mittels eines DC/DC-Wandlers, z. B. eines Schaltreglers, aus einer Basisspannung, z. B. einer Batteriespannung (z. B. 12 V bei einem Kraftfahrzeug) erzeugt werden muss und bei den Schaltvorgängen zugleich eine hohe Spannung und ein hoher Strom am Schalttransistor T1 vorliegen. Es ergeben sich somit relativ große Schaltverluste. Zwar können diese Schaltverluste bzw. die damit einhergehende hohe Momentanleistung am Schalttransistor T1 durch Vorsehen sehr kurzer Schaltzeiten etwas reduziert werden. Dies erhöht jedoch in nachteiliger Weise die EMV-Abstrahlung der Schaltung erheblich. Im Automobilbereich sind selbst mit zusätzlichen, kostspieligen Maßnahmen wie der Abschirmung eines Kabelbaumes zur induktiven Last (z. B. Einspritzventil) hin die in der Praxis geforderten Grenzwerte hinsichtlich der EMV nur schwer einzuhalten. Zur Bereitstellung der erhöhten Betriebsspannung V+ aus einer im Automobilbereich typischen Bordnetzspannung von z. B. 12 V ist ein leistungsstarker, teurer Schaltregler erforderlich, der die gesamte Leistung zum Betrieb der betreffenden Last liefern muss.

Eine Schattungsanordnung und ein Verfahren gemäß Oberbegriff der unabhängigen Ansprüche 1 und 8 ist aus Dokument JP 2001 015332 A bekannt.

Es ist eine Aufgabe der vorliegenden Erfindung, eine Schaltungsanordnung sowie ein Verfahren zum Betreiben einer induktiven Last, insbesondere eines Magnetventils eines Kraftstoffeinspritzsystems einer Brennkraftmaschine, bereitzustellen, bei welchen die oben erläuterten Nachteile verringert werden können und insbesondere ein rasches Ansprechen der Last bei gleichzeitig niedriger elektrischer Verlustleistung realisiert werden kann.

Diese Aufgabe wird gemäß der Erfindung durch eine Schaltungsanordnung nach Anspruch 1 bzw. ein Betriebsverfahren nach Anspruch 8 gelöst. Die abhängigen Ansprüche betreffen vorteilhafte Weiterbildungen der Erfindung.

Die erfindungsgemäße Schaltungsanordnung umfasst:
- Bestromungsmittel zum Bestromen der Last, die dazu ausgebildet sind, während einer ersten Betriebsphase eine erste Betriebsspannung an der Last anzulegen und während einer darauffolgenden zweiten Betriebsphase eine zweite Betriebsspannung, die kleiner als die erste Betriebsspannung ist, in intermittierender Weise an der Last anzulegen,
- Einstellmittel zum Steuern des intermittierenden Betriebs der Bestromungsmittel während der zweiten Betriebsphase zur Einstellung eines gewünschten Laststromes durch geeignetes Einschalten und Ausschalten der zweiten Betriebsspannung an der Last,
- Überwachungsmittel zum Überwachen der Erreichung des gewünschten Laststromes während der zweiten Betriebsphase, und
- Anpassungsmittel zum Anpassen der zweiten Betriebsspannung basierend auf dem Ergebnis der Überwachung.

Eine erste Grundidee der Erfindung besteht darin, eine funktionale Trennung von schnellem Stromaufbau zu Beginn einer Bestromungsphase ("erste Betriebsphase") und nachfolgender Laststromeinstellung ("zweite Betriebsphase") vorzusehen, wobei die Versorgung der Last während der ersten Betriebsphase aus einer "erhöhten Versorgungsspannung" und während der darauffolgenden zweiten Betriebsphase aus einer "normalen Versorgungsspannung" erfolgt ("Doppelspannungsversorgung").

Während der zweiten Betriebsphase wird der gewünschte Laststrom durch geeignetes Einschalten und Ausschalten der zweiten Betriebsspannung an der Last eingestellt. Dieser intermittierende Betrieb verursacht in der Praxis mehr oder weniger große Schaltverluste. Eine zweite Grundidee der Erfindung besteht darin, diese (auf Grund der relativ niedrigen zweiten Betriebsspannung ohnehin bereits reduzierten) Schaltverluste weiter zu reduzieren, indem die zweite Betriebsspannung angepasst wird, d. h. nicht fest vorgegeben sondern auf Basis einer Überwachung des Laststromes gegebenenfalls verändert wird. Ein entscheidender Vorteil der Anpassung (Veränderung) der zweiten Betriebsspannung besteht darin, dass eine solche Anpassung in der Praxis keine zusätzlichen nennenswerten Verluste hervorruft und die in der zweiten Betriebsphase auftretenden Schaltverluste ganz erheblich weiter reduzieren kann.

Für die Reduzierung der Schaltverluste durch Anpassung der zweiten Betriebsspannung sind zwei Effekte nutzbar. Zum einen kann durch die Anpassung gewährleistet werden, dass der Wert der zweiten Betriebsspannung stets nur so groß oder geringfügig größer ist, wie dies aktuell erforderlich ist (um im eingeschalteten Zustand den gewünschten Laststrom durch die Last zu treiben). Die somit relativ niedrige zweite Betriebsspannung führt zu entsprechend kleineren Verlusten bei jedem Schaltvorgang. Zum anderen verringert eine in dieser Weise angepasste zweite Betriebsspannung die Häufigkeit bzw. Frequenz der zur Einstellung des gewünschten Laststromes hervorgerufenen Schaltvorgänge. Auch dieser Effekt verringert die elektrischen Verluste in der zweiten Betriebsphase.

In einer bevorzugten Ausführungsform umfassen die Bestromungsmittel eine Schalttransistoranordnung (z. B. MOS-Transistoren) zum Einschalten und Ausschalten der zweiten Betriebsspannung an der Last.

Ferner ist die Anordnung wenigstens einer Freilaufdiode und/oder wenigstens einer Rekuperationsdiode bevorzugt, um nach einem Ausschaltvorgang einen Freilaufstrom weiterfließen zu lassen bzw. am Ende der Bestromungsphase eine Rückspeisung von elektrischer Energie in die elektrische Versorgung zu bewerkstelligen.

Die für einen schnellen Stromaufbau zu Beginn einer Bestromungsphase vorteilhaft erhöhte erste Betriebsspannung ist gemäß einer Ausführungsform um mindestens einen Faktor 1,5 größer als die zweite Betriebsspannung bzw. als ein Nominalwert dieser zweiten Betriebsspannung.

In einer bevorzugten Ausführungsform ist während der zweiten Betriebsphase ein PWM-Betrieb der Bestromungsmittel vorgesehen, wobei die Einstellmittel ein PWM-Tastverhältnis zur Einstellung, insbesondere Regelung, des gewünschten Laststromes variieren.

In einer schaltungstechnisch besonders einfachen Ausführungsform ist vorgesehen, dass die Einstellmittel eine Zweipunktregelung derart vorsehen, dass die zweite Betriebsspannung ausgeschaltet wird, sobald der Laststrom eine obere Stromgrenze erreicht und die zweite Betriebsspannung wieder eingeschaltet wird, sobald der Laststrom eine untere Stromgrenze erreicht. Eine hierfür erforderliche Strommessung kann z. B. durch einen in Reihe zur induktiven Last angeordneten Strommesswiderstand (Shunt) realisiert sein. Die obere Stromgrenze und die untere Stromgrenze können z. B. um denselben Betrag über bzw. unter dem Wert des gewünschten Laststromes von einer Steuereinrichtung vorgegeben werden, welcher auch ein für den aktuellen Laststrom repräsentatives Messsignal eingegeben wird.

Der Übergang von der ersten Betriebsphase zur zweiten Betriebsphase wird bevorzugt bei Erreichen einer oberen Stromgrenze initiiert, bei welcher es sich im einfachsten Fall um die zu Beginn der zweiten Betriebsphase verwendete obere Stromgrenze handelt. Für einfache Anwendungen können der gewünschte Laststrom in der zweiten Betriebsphase und dementsprechend die beiden Stromgrenzen zur Einstellung des Laststromes konstant vorgegeben werden. Es soll jedoch nicht ausgeschlossen sein, dass der gewünschte Laststrom und dementsprechend die beiden Stromgrenzen während der Dauer der zweiten Betriebsphase variiert werden.

In einer bevorzugten Ausführungsform ist vorgesehen, dass die Überwachungsmittel die Erreichung des gewünschten Laststromes durch eine Erfassung wenigstens eines damit einhergehenden Ausschaltens der zweiten Betriebsspannung während der zweiten Betriebsphase feststellen.

Falls die Schaltungsanordnung bzw. das Betriebsverfahren zum Betreiben mehrerer induktiven Lasten vorgesehen ist und eine gemeinsame zweite Betriebsspannung für diese Lasten verwendet wird, so können die Überwachungsmittel derart ausgebildet sein, dass ein von diesen Mitteln ausgegebenes Überwachungsergebnissignal repräsentativ dafür ist, ob der gewünschte Laststrom für alle Lasten erreicht wird oder ob der gewünschte Laststrom für wenigstens eine der Lasten nicht erreicht wird. Durch diese Maßnahme ("UND-Verknüpfung") der Überwachungsfunktionalität wird gewährleistet, dass die Anpassung der zweiten Betriebsspannung basierend auf dem Ergebnis der Überwachung einen ordnungsgemäßen Betrieb sämtlicher Lasten bewirkt.

In einer Weiterbildung der Erfindung ist vorgesehen, dass die Anpassungsmittel eine ständige Veränderung der zweiten Betriebsspannung bewirken, wobei von den Überwachungsmitteln das Vorzeichen der Veränderung vorgegeben wird. Durch diese Maßnahme kann eine besonders bedarfsgerechte Anpassung der zweiten Betriebsspannung realisiert werden. Dies ist in der Praxis von großem Vorteil. Würde nämlich die zweite Betriebsspannung über einen längeren Zeitraum durch die Anpassungsmittel "großzügig" (groß) bemessen werden, so würde dies zwar ein zuverlässiges Erreichen des gewünschten Laststromes in der zweiten Betriebsphase sicherstellen, gleichzeitig jedoch die Schaltverluste unnötig vergrößern. Würde die Anpassung andererseits die zweite Betriebsspannung über längere Zeiträume "knapp" (klein) bemessen, so bestünde die Gefahr, dass der gewünschte Laststrom in der zweiten Betriebsphase nicht zuverlässig erreicht wird. Mit der vorstehend erwähnten Maßnahme kann jedoch vorteilhaft insbesondere z. B. eine Zweipunktregelung derart realisiert werden, dass
- im Falle einer durch die Überwachungsmittel festgestellten Erreichung des gewünschten Laststromes die zweite Betriebsspannung verringert wird, und
- im Falle einer durch die Überwachungsmittel festgestellten Nichterreichung des gewünschten Laststromes die zweite Betriebsspannung erhöht wird.

Durch eine solche Zweipunktregelung wird gewissermaßen gewährleistet, dass die zweite Betriebsspannung "um ein Optimum pendelt". Für viele Anwendungen ist hierbei jedoch zu bedenken, dass jeder Fall einer Nichterreichung des gewünschten Laststromes mehr oder weniger nachteilig sein kann bzw. nicht so häufig vorkommen sollte. Vor diesem Hintergrund ist in vielen Anwendungsfällen eine Weiterbildung äußerst vorteilhaft, gemäß welcher die im Falle der Erreichung des gewünschten Laststromes bewirkte Verringerung der zweiten Betriebsspannung wesentlich langsamer vonstatten geht als die im Falle der Nichterreichung bewirkte Erhöhung der zweiten Betriebsspannung. Entsprechende, z. B. im Wesentlichen linear erfolgende Verringerungen bzw. Erhöhungen der zweiten Betriebsspannung können sich hinsichtlich der zeitlichen Veränderungsrate z. B. um wenigstens einen Faktor 2 voneinander unterscheiden.

In vielen Anwendungsfällen besteht ein besonderer Vorteil der Erfindung darin, dass alterungsbedingte Veränderungen der elektrischen Eigenschaften der elektrischen Komponenten der Schaltungsanordnung, der zu betreibenden induktiven Last und etwaiger "Verkabelungen" (z. B. zwischen einem Steuergerät und einer Einspritzanlage in einem Kraftfahrzeug) durch die erfindungsgemäße Einstellung des gewünschten Laststromes in der zweiten Betriebsphase in weiten Grenzen kompensiert werden können, indem der gewünschte Laststrom in der zweiten Betriebsphase geregelt wird. Eine Erhöhung ohmscher Anteile der Lastimpedanz bzw. einer elektrischen Verbindungsanordnung zwischen der Schaltungsanordnung und der oder den Lasten wird dann "weggeregelt". Trotzdem ist es in der Praxis oftmals wünschenswert, derartige Degradationen in einem elektrischen System festzustellen bzw. zu diagnostizieren. In einer bevorzugten Weiterbildung der Erfindung sind in dieser Hinsicht weitere Überwachungsmittel zum Überwachen der zweiten Betriebsspannung im Hinblick auf die Unterschreitung einer unteren Spannungsgrenze und/oder auf die Überschreitung einer oberen Spannungsgrenze vorgesehen. In der Praxis ist insbesondere die Überwachung im Hinblick auf die Überschreitung einer oberen Spannungsgrenze besonders relevant, wenn es z. B. darum geht, eine Erhöhung von ohmschen Verlusten festzustellen.

Die Erfindung wird nachfolgend anhand von Ausführungsbeispielen mit Bezug auf die beigefügten Zeichnungen weiter beschrieben. Es stellen dar:
- Fig. 1: eine prinzipielle Schaltungsanordnung (Endstufe) zum PWM-Betrieb einer induktiven Last,
- Fig. 2: Spannungs- und Stromverläufe beim PWM-Betrieb der Schaltungsanordnung von Fig. 1,
- Fig. 3: eine prinzipielle Schaltungsanordnung (Endstufe) mit einer Doppelspannungsversorgung zum Betrieb einer induktiven Last,
- Fig. 4: Spannungs- und Stromverläufe bei einem "verein- fachten" Betrieb der Schaltungsanordnung von Fig. 3,
- Fig. 5: Spannungs- und Stromverläufe beim Betrieb der Schaltungsanordnung von Fig. 3 mit Doppelspan- nungsversorgung und PWM-Betrieb,
- Fig. 6: eine Ablaufsteuerung zum Betrieb der Endstufe nach Fig. 3,
- Fig. 7: Signalverläufe in der Ablaufsteuerung von Fig. 6,
- Fig. 8: eine Betriebsstromauswertung für die Ablaufsteue- rung von Fig. 6,
- Fig. 9: Signalverläufe in der Betriebsstromauswertung von Fig. 8,
- Fig. 10: eine Verknüpfungsschaltung zur Verknüpfung mehre- rer Ablaufsteuerungen nach Fig. 6,
- Fig. 11: Signalverläufe in der Verknüpfungsschaltung von Fig. 10,
- Fig. 12: eine bipolare Stromquelleneinrichtung zur Steue- rung einer Referenzspannung,
- Fig. 13: Signalverläufe in der Einrichtung von Fig. 12 zur Verdeutlichung der Referenzspannungssteuerung, und
- Fig. 14: ein Prinzipschaltbild eines DC/DC-Wandlers zur Erzeugung einer Versorgungsspannung ("zweite Be- triebsspannung") für die Endstufe von Fig. 3.

Die Fig. 1 und 2 veranschaulichen eine prinzipielle Schaltungsanordnung zum PWM-Betrieb einer induktiven Last L1 (Fig. 1) sowie beispielhafte Verläufe einer Lastspannung VL und eines Laststromes IL in Abhängigkeit von der Zeit t (Fig. 2).

Aufbau, Funktionsweise und Nachteile der in Fig. 1 dargestellten Schaltungsanordnung (Endstufe) wurden eingangs bereits erläutert.

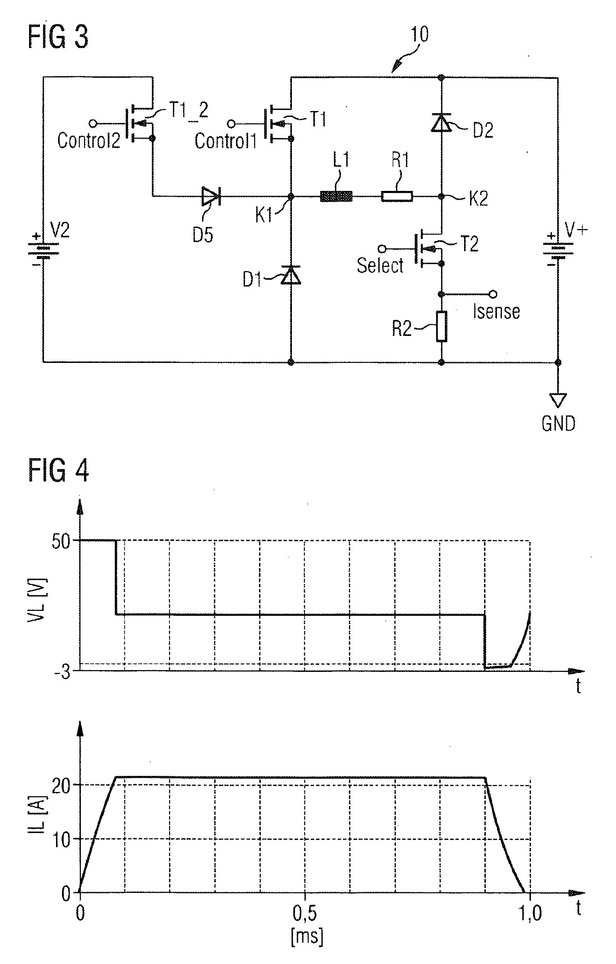

Nachfolgend wird mit Bezug auf die Fig. 3 bis 14 eine erfindungsgemäße Schaltungsanordnung zum Betreiben einer induktiven Last erläutert, bei welcher diese Nachteile weitgehend beseitigt sind und insbesondere ein verlustarmer Betrieb bei gleichzeitig präziser Laststromeinstellung ermöglicht wird.

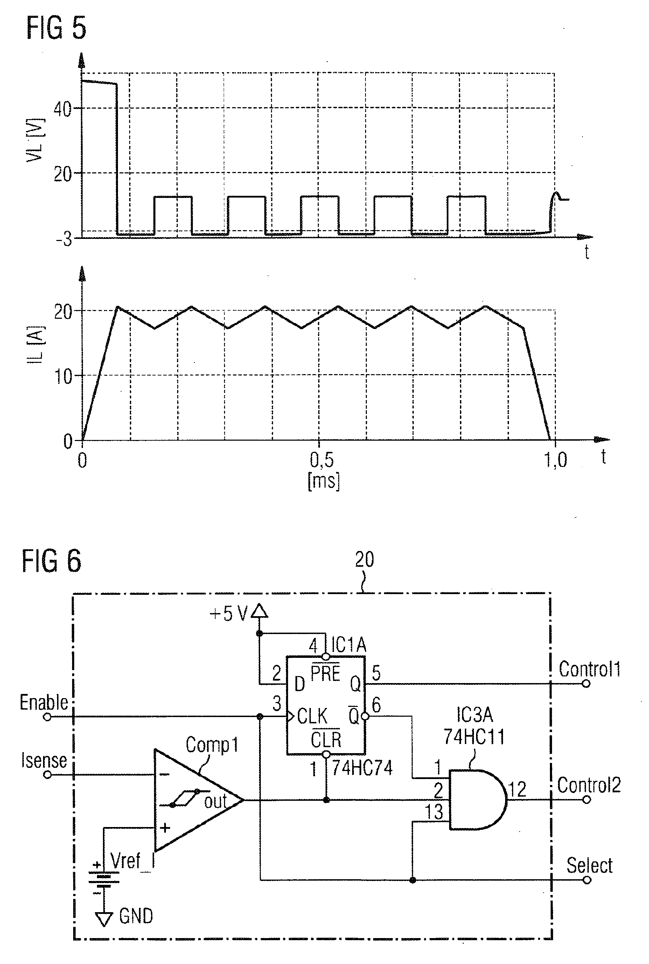

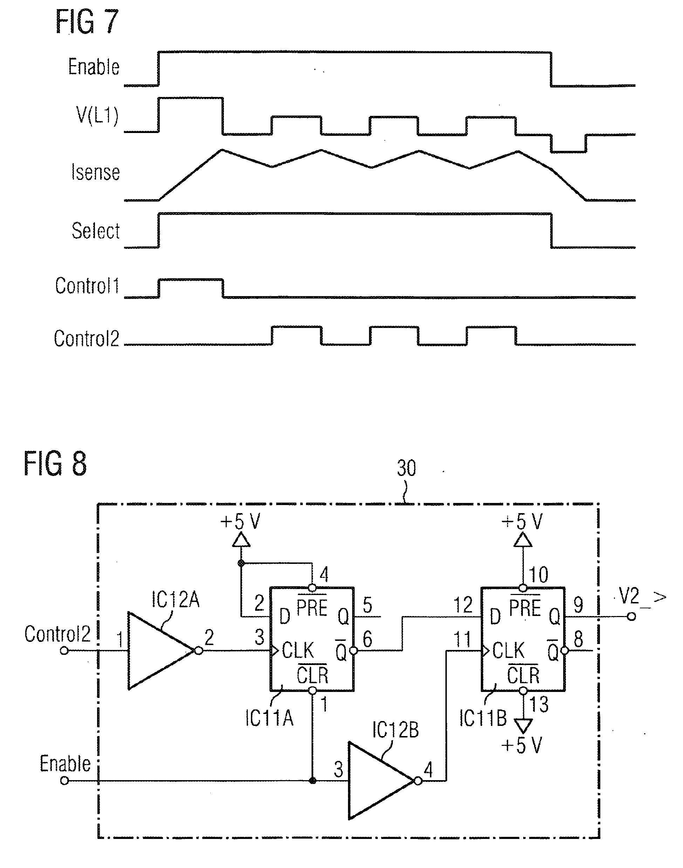

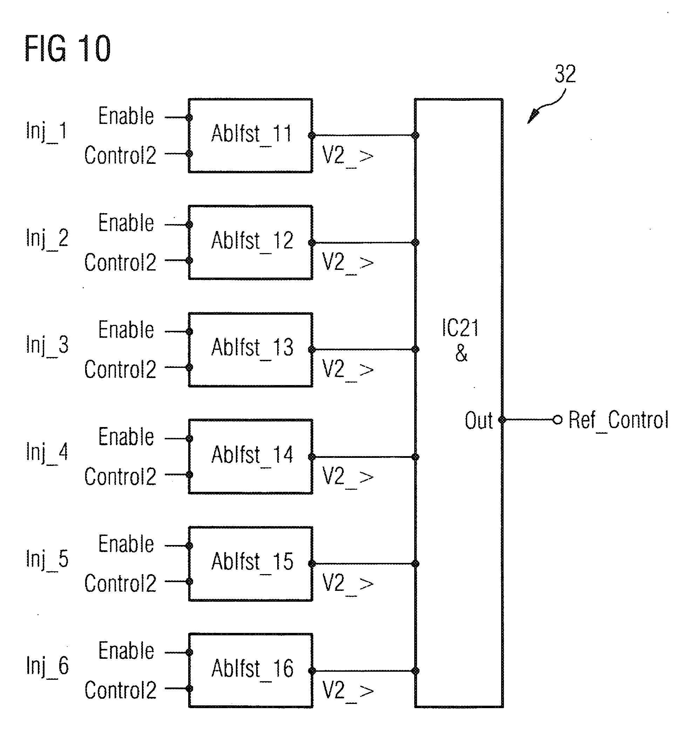

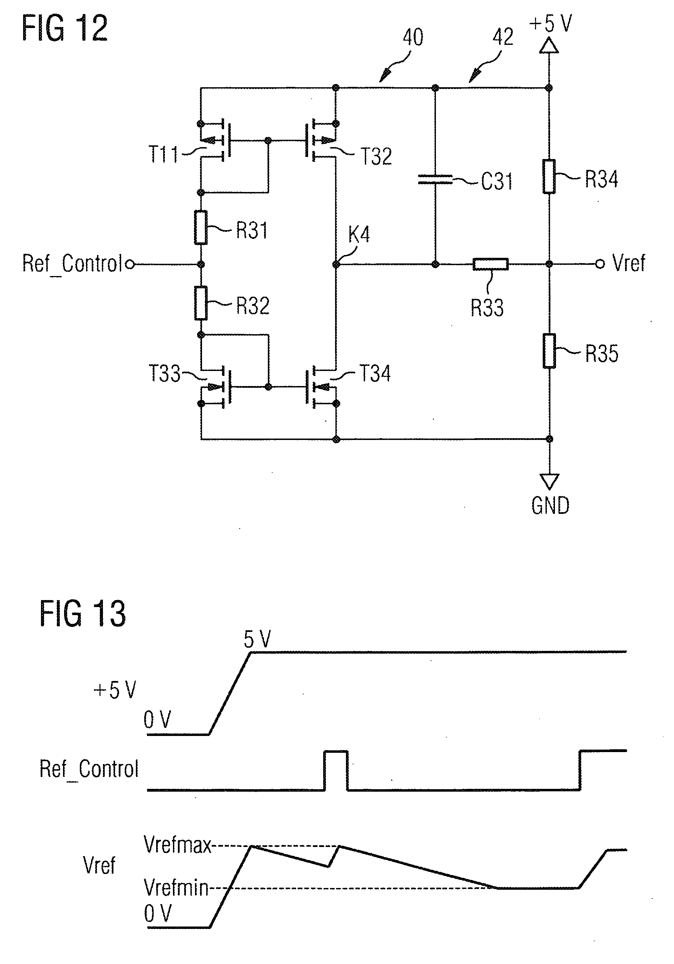

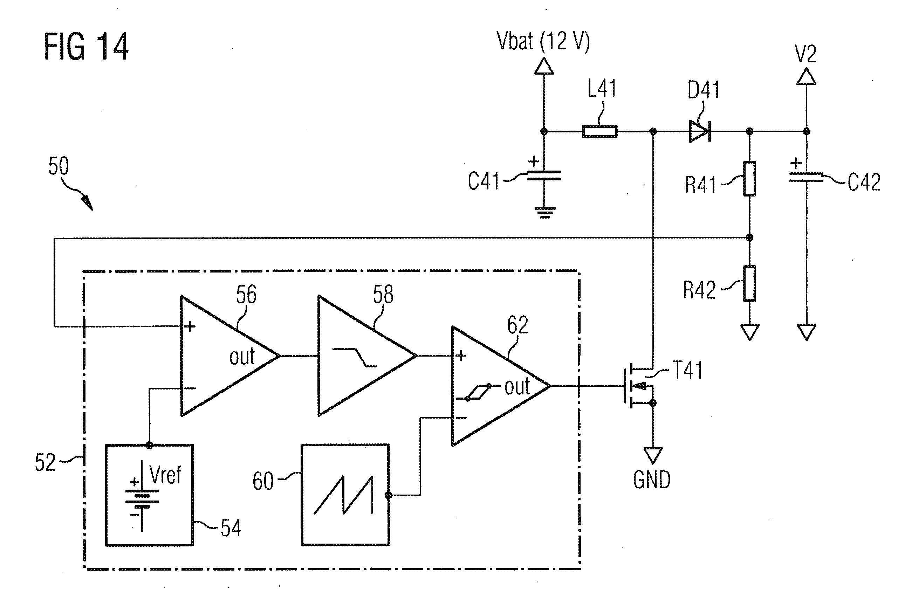

Die erfindungsgemäße Schaltungsanordnung umfasst eine Endstufe nach Fig. 3, eine Ablaufsteuerung nach Fig. 6, eine Betriebsstromauswertung nach Fig. 8, optional eine Verknüpfungsschaltung nach Fig. 10, eine bipolare Stromquelleneinrichtung nach Fig. 12 sowie einen DC/DC-Wandler nach Fig. 14. Der Aufbau dieser Schaltungsteile wird nachfolgend beschrieben und bezüglich der Funktionsweise durch jeweilige beispielhafte Signalverläufe verdeutlicht.

Eine Besonderheit der in Fig. 3 dargestellten Endstufe 10 im Vergleich zu der Endstufe von Fig. 1 besteht darin, dass diese Endstufe von zwei Spannungsquellen versorgt wird, welche eine erste Betriebsspannung V+ sowie eine zweite Betriebsspannung V2 liefern, die (etwa um einen Faktor 2) kleiner als die erste Betriebsspannung V+ ist.

Ausgehend von einem ersten (hier positiven) Anschluss der ersten Betriebsspannungsquelle verläuft ein Pfad über einen Transistor T1, die induktive Last L1, einen Widerstand R1, einen Transistor T2 und einen Widerstand R2 zu einem zweiten (hier negativen) Anschluss der ersten Betriebsspannungsquelle. Der Widerstand R1 symbolisiert in der Praxis unvermeidbare elektrische Widerstände von Leitungsanordnungen bzw. Übergangskontakten im Bereich dieses Strompfads bzw. zwischen der eigentlichen Endstufe und der induktiven Last L1. Der Widerstand R2 dient einer nicht dargestellten Steuereinrichtung als Strommesseinrichtung zur Messung des aktuell durch die Last L1 fließenden Laststromes IL. Ein Spannungsabfall an dem "Shuntwiderstand" R2 wird als Sensorsignal Isense der Steuereinrichtung zugeführt. Die Steuereinrichtung erzeugt im Betrieb die in Fig. 3 dargestellten Steuersignale Control1, Select und Control2 zur Ansteuerung (Einschalten und Ausschalten) der dargestellten Transistoren T1, T2 und T1_2. Ein Schaltungsknoten K1, welcher den Transistor T1 mit der Last L1 verbindet, ist in der dargestellten Weise über eine Freilaufdiode D1 mit dem zweiten Anschluss der ersten Betriebsspannungsquelle verbunden. Ein Schaltungsknoten K2, welcher den Widerstand R1 mit dem Transistor T2 verbindet, ist in der dargestellten Weise über eine Rekuperationsdiode D2 mit dem ersten Anschluss der ersten Betriebsspannungsquelle verbunden.

Mit den bis hierher beschriebenen Schaltungskomponenten der Endstufe 10 könnte ein Endstufenbetrieb erfolgen, der bereits mit Bezug auf die Fig. 1 und 2 beschrieben wurde. Zur funktionalen Trennung eines schnellen Stromaufbaus in einer ersten Betriebsphase und einer Stromeinstellung in einer zweiten Betriebsphase ist bei der Endstufe 10 jedoch die zusätzliche zweite Betriebsspannungsquelle (Spannung V2) vorgesehen. Ein in seiner Polarität dem ersten Anschluss der ersten Betriebsspannungsquelle entsprechender erster Anschluss der zweiten Betriebsspannungsquelle (hier positiver Anschluss) ist über den Transistor T1_2 und eine in Flussrichtung gepolte Diode D5 mit dem Schaltungsknoten K1 verbunden. Der zweite (hier negative) Anschluss der zweiten Betriebsspannungsquelle ist mit dem zweiten Anschluss der ersten Betriebsspannungsquelle (und gegebenenfalls mit einer elektrischen Masse) verbunden.

Der erfindungsgemäße Betrieb der Endstufe 10 wird weiter unten mit Bezug auf Fig. 5 beschrieben. Zur Verdeutlichung der funktionalen Trennung von schnellem Stromaufbau und Stromeinstellung als solcher, die mit der Endstufe 10 realisiert ist, soll jedoch zunächst mit Bezug auf Fig. 4 ein prinzipiell ebenso möglicher "reiner Doppelspannungsbetrieb" (ohne PWM-Stromeinstellung) erläutert werden. Dieser vereinfachte (nicht erfindungsgemäße) Betrieb funktioniert wie folgt:

Zu Beginn einer Bestromungsphase werden T1 und T2 eingeschaltet. An der induktiven Last L1 liegt dann im Wesentlichen die erste Betriebsspannung V+, nachfolgend auch als "Boostspannung" bezeichnet, an und der Laststrom IL durch die Last L1 steigt schnell an. Ist der für die Bestromungsphase gewünschte Laststrom erreicht, was durch Auswertung des Strommessignals Isense leicht erfasst werden kann, so wird T1 ausgeschaltet und T1_2 eingeschaltet. Von diesem Zeitpunkt an wird der Laststrom IL von der zweiten Betriebsspannungsquelle aus der zweiten Betriebsspannung V2 geliefert. Er fließt ausgehend vom positiven Anschluss der zweiten Betriebsspannungsquelle über den Transistor T1_2, die Diode D5, die Last L1, den Widerstand R1, den Transistor T2 und den Strommesswiderstand R2 zum zweiten Anschluss der zweiten Betriebsspannungsquelle.

In dieser zweiten Betriebsphase hängt der Laststrom IL von der zweiten Betriebsspannung V2, der Flussspannung der Diode D5 und der Summe der Widerstände (hier symbolisiert durch R1 und R2) im Strompfad ab. In der Praxis ergeben sich solche Strompfadwiderstände insbesondere durch einen ohmschen Anteil der Lastimpedanz, durch Leitungs- und Kontaktübergangswiderstände, Einschaltwiderstände der Transistoren T1_2, T2 etc.

Die sich ergebenden Verläufe der Lastspannung VL und des Laststromes IL sind in Fig. 4 in Abhängigkeit von der Zeit t dargestellt.

Da in der Praxis insbesondere die Summe der Widerstände im Strompfad Variationen unterworfen ist, wird durch diesen prinzipiell möglichen reinen Doppelspannungsbetrieb eine präzise Einstellung des Laststromes IL auf einen gewünschten Laststrom erheblich erschwert.

Gemäß der Erfindung wird daher in der zweiten Betriebsphase, in welcher die Last L1 aus der zweiten Betriebsspannungsquelle versorgt wird, eine Einstellung des gewünschten Laststromes IL durch geeignetes Einschalten und Ausschalten der zweiten Betriebsspannung V2 vorgesehen.

Dieser beispielhaft durch Fig. 5 veranschaulichte Betrieb mit Doppelspannungsversorgung und PWM-Einstellung funktioniert wie folgt: In der zweiten Betriebsphase wird T1_2 nicht statisch eingeschaltet sondern wiederholt eingeschaltet und ausgeschaltet, wodurch sich im zeitlichen Mittel ein mittlerer Wert für den Laststrom IL ergibt (PWM-Betrieb). Durch eine geeignete Variation des Tastverhältnisses lässt sich so der gewünschte Stromwert genauer einstellen bzw. regeln (z. B. so wie oben mit Bezug auf die Fig. 1 und 2 beschrieben).

Dieses Schaltungs- bzw. Betriebskonzept zum Betrieb der induktiven Last L1, beispielsweise zur Betätigung eines Magnetventils, besitzt etliche Vorteile. Ein erster Vorteil besteht darin, dass ein DC/DC-Wandler, insbesondere Schaltregler, der die erhöhte zweite Betriebsspannung V+ aus einer Basisspannung (z. B. Bordnetzspannung von 12 V bei einem Kraftfahrzeug) erzeugt, nur während der ersten Betriebsphase (Stromaufbau) belastet wird. Der Wirkungsgrad eines solchen DC/DC-Wandlers spielt daher eine geringere Rolle für den Gesamtwirkungsgrad des Systems. Außerdem kann dieser Wandler dadurch wesentlich kleiner und somit kostengünstiger gestaltet werden. Die hohe Momentanleistung am Schalttransistor T1 tritt nur ein Mal beim Ausschalten auf. Ein weiterer Vorteil besteht darin, dass T1_2 aus einer niedrigeren Spannung (zweite Betriebsspannung V2) gespeist wird, so dass die an T1_2 auftretenden Schaltverluste in der zweiten Betriebsphase entsprechend geringer sind. Auch ist die Schaltfrequenz geringer, da sich der Laststrom IL dementsprechend langsamer ändert. Dies hat wiederum auch vorteilhaft zur Folge, dass die Zeiten, während derer der Schalttransistor T1_2 eingeschaltet oder ausgeschaltet ist, sich wesentlich erhöhen, was sich positiv bei der EMV-Abstrahlung bemerkbar macht. Schließlich kann in der Praxis oftmals eine zusätzliche, kostspielige Abschirmung einer Leitungsanordnung (z. B. Kabelbaum) zur Last L1 entfallen. Die praktisch geforderten EMV-Grenzwerte sind wesentlich leichter einzuhalten.

Prinzipiell wäre es denkbar, die Endstufe 10 mit einer konstanten zweiten Betriebsspannung V2 bzw. z. B. mit einer Batteriespannung eines Kraftfahrzeugs zu versorgen. Dies ist beim erfindungsgemäßen Betrieb der Endstufe 10 nicht vorgesehen, da sich in diesem Fall für viele Anwendungsfälle eine gravierende Problematik ergibt. Zum besseren Verständnis der erfindungsgemäß vorgesehenen Gestaltung der zweiten Betriebsspannungsquelle soll nachfolgend zunächst diese Problematik erläutert werden.

Wie bereits erwähnt, ist bei der Endstufe 10 der in der zweiten Betriebsphase (Versorgung aus der zweiten Betriebsspannungsquelle) maximal mögliche Laststrom IL im Wesentlichen durch den Wert der zweiten Betriebsspannung V2 und die Summe der Widerstände im Strompfad (R1 und R2 in Fig. 3) bestimmt. Um nun einen gewünschten Laststrom IL in der zweiten Betriebsphase überhaupt erreichen zu können, muss V2 zumindest einen minimalen Wert besitzen, der umso größer ist, je größer diese Widerstände (und z. B. die Flussspannung der Diode D5) sind. In der Praxis, insbesondere bei Anwendung im Bereich der Automobilelektronik, ergeben sich z. B. temperatur- und alterungsbedingte Änderungen der Widerstände (Lastwiderstand, Leitungs- und Kontaktübergangswiderstände, Einschaltwiderstände der Transistoren etc.). Daher muss V2 vorsorglich größer gewählt werden als es im Normalfall (Idealfall) erforderlich wäre. Allein die temperaturbedingte Widerstandszunahme beträgt für einen - im Automobilbereich bei motornahem Anbau typischen - Bereich von -30°C bis +150°C über 75 %!

Bei einem System mit mehreren induktiven Lasten wie der dargestellten Last L1 (z. B. bei einem Einspritzsystem für einen 6-Zylinder-Motor mit 6 Einspritzventilen) muss außerdem stets die Last mit dem höchsten Gesamtwiderstand im Laststrompfad bei der Auslegung des Werts von V2 berücksichtigt werden. Da sich in einer Großserie im Automobilbereich eine Batteriespannung bzw. Versorgungsspannung nicht beliebig genau einstellen lässt, sind weitere Zuschläge für Bauteil- und Fertigungstoleranzen dann unvermeidlich. Ein typischer Wert hierfür ist z. B. +/- 10 %.

Für den Fall einer Bereitstellung der zweiten Betriebsspannung V2 unmittelbar als Batteriespannung eines Kraftfahrzeugs (z. B. mit einem Nominalwert von 12 V) müsste daher ein DC/DC-Wandler vorgesehen werden, welcher aus der Batteriespannung eine um etwa 85 % erhöhte zweite Versorgungsspannung V2 erzeugt (z. B. 22 V). Dies wiederum hat eine Reihe von gravierenden Nachteilen. Die Spannung der im Kraftfahrzeug verfügbaren 12 V-Versorgung reicht nicht mehr aus. Die Spannung V2 muss mittels eines weiteren DC/DC-Wandlers z. B. aus der 12 V-Bordnetzspannung erzeugt werden (Kosten, Bauraum). Dieser zweite Wandler erzeugt Verluste, die mit steigender Ausgangsspannung ebenfalls anwachsen. Wegen der Eingangsstromwelligkeit des Wandlers werden zusätzliche EMV-Filtermaßnahmen notwendig. Die gegenüber der Bordnetzspannung erhöhte Spannung V2 (z. B. 22 V) führt zu überproportional erhöhten Schaltverlusten im Transistor T2, da an diesem Transistor eine höhere Schaltspannung anliegt. Außerdem ergeben sich mehr Schaltvorgänge bzw. eine höhere Schaltfrequenz, da der Laststrom IL sich im intermittierenden Betrieb schneller ändert. Dies wiederum hat außerdem eine erhöhte EMV-Abstrahlung wegen der höheren Schaltamplitude und -frequenz zur Folge.

Prinzipiell wäre es denkbar, diese Problematik durch folgende Maßnahmen zu verringern: Minimierung der Werte und Toleranzen der Widerstände im Strompfad, was höhere Kosten mit sich bringen würde; Minimierung der Toleranzen für die Einstellung bzw. Regelung von V2, was teurere Bauteile und Probleme in der Langzeitstabilität mit sich bringen würde; Zusatzaufwendungen bei der Entwärmung der Endstufe, was eine teurere Mechanik zur Folge hätte; umfangreiche Analysen und Messungen, um den im jeweiligen Anwendungsfall minimal erforderlichen Wert von V2 zu finden.

Bei dem erfindungsgemäßen Betrieb der Endstufe 10 wird jedoch ein ganz anderer Weg beschritten, bei welchem die Erreichung des gewünschten Laststromes während der zweiten Betriebsphase durch Überwachungsmittel überwacht wird und basierend auf dem Ergebnis dieser Überwachung eine Anpassung der zweiten Betriebsspannung V2 erfolgt. Bei den nachfolgend beschriebenen Schaltungsteilen zur Realisierung dieser Anpassung wird V2 dynamisch derart geregelt, dass der gewünschte Laststrom IL unabhängig von den vorstehend beschriebenen Einflussgrößen stets knapp, aber sicher erreicht wird. Eine beispielhafte Art und Weise der Realisierung der Anpassung wird nachfolgend anhand der Fig. 6 bis 14 erläutert.

Fig. 6 zeigt das Schaltbild einer Ablaufsteuerung 20 zum Betrieb der Endstufe nach Fig. 3. Die Ablaufsteuerung 20 umfasst wie dargestellt einen hysteresebehafteten Spannungsvergleicher Comp1, ein D-Flipflop IC1A und ein Dreifach-UND-Gatter IC3A.

Die Ablaufsteuerung 20 schaltet die Transistoren T1, T1_2 und T2 (Steuersignale Control1, Control2 und Select) in Abhängigkeit von den Pegeln der Steuersignal Enable und Isense:
- Zunächst werden die Transistoren T1 und T2 eingeschaltet (Beginn der Bestromungsphase; Enable springt von "low"-auf "high"-Pegel). Der Strom durch T1, L1, T2, R2 steigt, bis Isense einen vorbestimmten oberen Wert erreicht hat.
- T1 wird ausgeschaltet, sobald das Messsignal Isense am Widerstand R1 den oberen Wert erreicht hat. Der Strom durch T1, L1, T2, R2 wird daraufhin langsam sinken, bis Isense einen unteren Wert erreicht hat.
- T1_2 wird eingeschaltet, sobald Isense den unteren Wert erreicht hat. Daraufhin steigt der Strom durch T1, L1, T2, R2 wiederum an, bis Isense den oberen Wert wieder erreicht hat.
- T1_2 wird wieder ausgeschaltet, sobald Isense den oberen Wert erreicht hat usw.
- T1_2 und T2 werden beide ausgeschaltet (Ende der Bestromungsphase; Enable springt von "high"- auf "low"-Pegel).

Diese Funktion der in Fig. 6 dargestellten Ablaufsteuerung 20 (vgl. auch die in Fig. 7 dargestellten Signalverläufe) sei nachfolgend nochmals im Detail erläutert.

Startbedingung - Die Endstufe 10 ist nicht aktiviert:

Das Flipflop IC1A ist zurückgesetzt, so dass sein nicht-invertierender Ausgang Q "low"-Pegel hat und sein invertierender Ausgang Q-Nicht "high"-Pegel. Das Ausgangssignal Control1 hat deshalb "low"-Pegel.

Der Steuereingang Enable habe "low"-Pegel. Das Ausgangssignal Select hat deshalb "low"-Pegel. Die Spannung am Eingang Isense sei Null. Vref_I bezeichnet eine vorgegebene Laststromreferenz, mit welcher Isense verglichen wird. Dadurch nimmt der Ausgang von Comp1 "high"-Pegel an, so dass der "low"-aktive Eingang CLR-Nicht des Flipflops IC1A nicht gesetzt wird.

Die Eingänge des UND-Gatters IC3A sind nun verbunden mit: Q-Nicht des Flipflops ("high"-Pegel), Ausgang des Spannungsvergleichers ("high"-Pegel), und Steuersignal Enable ("low"-Pegel).Dementsprechend hat das Ausgangssignal Control2 "low"-Pegel. T1_2 ist ausgeschaltet.

### Aktivierung der Endstufe:

Das Eingangssignal Enable springt auf "high"-Pegel. Dementsprechend springt das Signal Select auf "high"-Pegel und schaltet den Transistor T2 (Fig. 3) ein.

Mit dem Sprung des Enable-Signals wird auch das Flipflop IC1A getriggert, so dass sein nicht-invertierender Ausgang Q auf "high"-Pegel springt. Das Ausgangssignal Control1 springt auf "high"-Pegel und schaltet den Transistor T1 (Fig. 3) ein.

Der invertierende Ausgang Q-Nicht springt auf "low"-Pegel. Die Eingangssignale des UND-Gatters IC3A sind nun verbunden mit Q-Nicht des Flipflops ("low"-Pegel), Ausgang des Spannungsvergleichers ("high"-Pegel) und Steuersignal Enable ("high"-Pegel). Dementsprechend hat das Ausgangssignal Control2 "low"-Pegel. T1_2 bleibt ausgeschaltet.

Nun sind T1 und T2 eingeschaltet und es beginnt der Laststrom IL von V+ durch T1, L1, R1, T2, R2 nach Masse GND zu fließen (vgl. Fig. 3). Entsprechend steigt die Spannung Isense am Widerstand R2 an. Überschreitet der Wert von Isense den Wert von Vref_I zuzüglich der Hysterese des Spannungsvergleichers Comp1, so springt der Ausgang des Spannungsvergleichers auf "low"-Pegel.

### Umschalten der Endstufenversorgung von V+ auf V2:

Da der Ausgang des Spannungsvergleichers Comp1 auf "low"-Pegel liegt, wird das Flipflop IC1A über seinen damit verbundenen CLR-Nicht-Eingang zurückgesetzt. Dadurch springt das Signal des nicht-invertierenden Ausgangs Q auf "low"-Pegel und der Steuerausgang Control1 nimmt "low"-Pegel an. Dies schaltet den Transistor T1 aus, so dass L1 (Fig. 3) nicht mehr mit der Boostspannung V+ verbunden ist.

Der Stromfluss durch L1 nimmt jetzt langsam ab, wobei sich die Spannung am Knoten "Kathoden von D1, D5, Source von T1, L1" - getrieben durch die elektromotorische Kraft (EMK) der induktiven Last L1 - umdreht und der Strom nun durch D1 nach Masse fließt. Dadurch sinkt auch der Wert von Isense langsam ab.

Sinkt der Wert von Isense unter den Wert von Vref_I abzüglich der Hysterese des Spannungsvergleichers Comp1, so springt der Ausgang des Spannungsvergleichers auf "high"-Pegel. Dies hat keine Auswirkung auf das Flipflop IC1A oder den Steuerausgang Control1 ("low"). Die Eingangssignale des UND-Gatters IC3A sind nun jedoch verbunden mit: Q-Nicht des Flipflops ("high"-Pegel), Ausgang des Spannungsvergleichers ("high"-Pegel), und Steuersignal Enable ("high"-Pegel). Dementsprechend hat das Ausgangssignal Control2 "high"-Pegel. T1_2 wird nun geschaltet.

Damit ist L1 mit V2 verbunden und der Strom beginnt erneut zu steigen. Entsprechend steigt auch die Spannung Isense wiederum, bis ihr Wert den Wert von Vref_I zuzüglich der Hysterese des Spannungsvergleichers Comp1 übersteigt, woraufhin der Ausgang des Spannungsvergleichers wieder auf "low"-Pegel springt. Damit wird das Signal Control2 auf "low"-Pegel gesteuert und T1_2 ausgeschaltet. Es beginnt eine erneute Freilaufphase mit fallendem Stromfluss durch D1, bis der Wert von Isense abermals den Wert von Vref_I zuzüglich der Hysterese des Spannungsvergleichers Comp1 unterschreitet und T1_2 abermals eingeschaltet wird.

Es wird also T1_2 wiederholt ein- und ausgeschaltet und der Laststrom durch L1 pendelt um einen mittleren Wert herum.

### Ausschalten der Endstufe:

Zum Ende der Aktivierungsphase der Endstufe 10 schaltet das Steuersignal Enable auf "low"-Pegel. Dadurch springt das Ausgangssignal Select auf "low"-Pegel und T2 schaltet aus. Der Ausgang des UND-Gatters - und damit das Ausgangssignal Control2 - springt ebenfalls auf "low"-Pegel und schaltet T1_2 aus.

Damit ist L1 beidseitig freigeschaltet. Getrieben durch seine EMK kehrt sich die Spannung an L1 um und der Strom fließt nun durch D1 und D2, so dass sich L1 rasch in die Versorgung V+ entlädt. Der Ursprungszustand ist nun wiederhergestellt.

Bis hierher zusammengefasst bildet die Endstufe 10 (Fig. 3) Bestromungsmittel zum Bestromen der induktiven Last L1, die dazu ausgebildet sind, während einer ersten Betriebsphase eine erste Betriebsspannung V+ an der Last anzulegen und während einer darauffolgenden zweiten Betriebsphase eine zweite Betriebsspannung V2, die kleiner als die erste Betriebsspannung V+ ist, in intermittierender Weise an der Last anzulegen. Die Ablaufsteuerung 20 (Fig. 6) bildet Einstellmittel zum Steuern des intermittierenden Betriebs der Endstufe 10 während der zweiten Betriebsphase zur Einstellung eines gewünschten Laststromes durch geeignetes Einschalten und Ausschalten der zweiten Betriebsspannung V2 an der Last L1, R1.

An dieser Stelle ist anzumerken, dass bei einem System mit mehreren induktiven Lasten (z. B. mehrere Einspritzventile einer Brennkraftmaschine) entsprechend mehrere Ablaufsteuerungen der in Fig. 6 dargestellten Art vorgesehen sind und mehrere eingangsseitige Steuersignale (Enable1, Enable2, ...) verwendet werden. Wie es unten noch beschrieben wird, wird in diesem Fall für die Anpassung der zweiten Betriebsspannung V2 die Last mit dem höchsten Gesamtwiderstand im Strompfad berücksichtigt. In der Praxis ist es nämlich oftmals schwer vorhersagbar, welche von mehreren Lasten zu einem gegebenen Zeitpunkt den höchsten Widerstandswert hat.

Fig. 8 zeigt das Schaltbild einer Betriebsstromauswertung 30 zum Überwachen der Erreichung des gewünschten Laststromes IL während der zweiten Betriebsphase.

Die Betriebsstromauswertung 30 umfasst wie dargestellt zwei Inverter IC12A, IC12B und zwei D-Flipflops IC11A, IC11B.

Der Betriebsstromauswertung 30 werden eingangsseitig die Signale Enable und Control2 eingegeben, woraus ausgangsseitig ein Signal V2_> gebildet wird. Die Betriebsstromauswertung 30 bzw. das davon gebildete Signal V2_> dient dazu, das Erreichen der oberen Stromgrenze (Umschalten des in der Ablaufsteuerung von Fig. 6 ersichtlichen Komparators Comp1) während der zweiten Betriebsphase festzustellen. Dies ist an einer Betätigung des Transistors T1_2 während der Dauer des Signals Enable zu erkennen, das Signal Control2 muss also wenigstens einmal den "high"-Pegel annehmen.

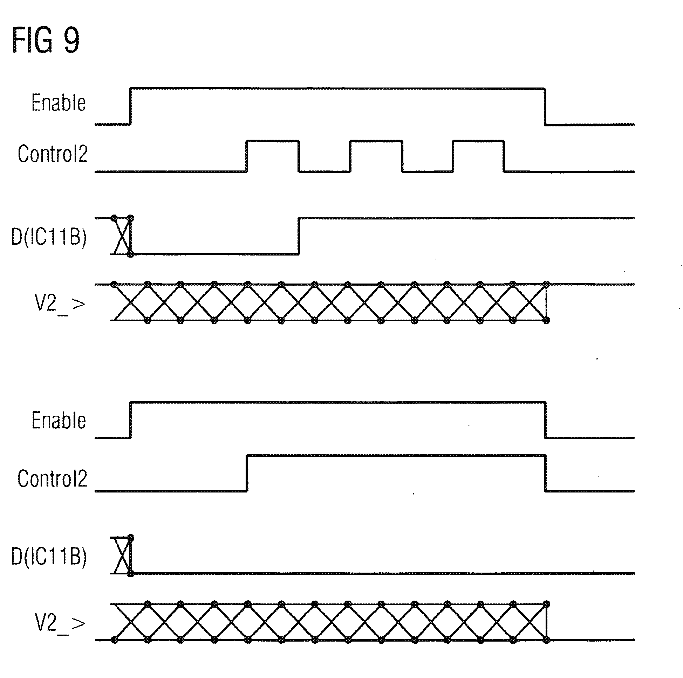

Fig. 9 zeigt zeitliche Verläufe von auftretenden Signalen für zwei mögliche Betriebsfälle. Die im oberen Teil der Fig. 9 dargestellten Signalverläufe ergeben sich für einen Betriebsfall, in welchem während der zweiten Betriebsphase die obere Stromgrenze (und somit selbstverständlich auch der gewünschte Laststrom) erreicht wird (unten als "1. Fall" bezeichnet). Im dargestellten Zeitraum wird die obere Stromgrenze sogar drei Mal erreicht, was an den drei Variationen des Signals Control2 zu erkennen ist.

Die im unteren Teil der Fig. 9 dargestellten Signalverläufe veranschaulichen einen Betriebsfall, in welchem die obere Stromgrenze nicht erreicht wird (unten als "2. Fall" bezeichnet).

Diese Überwachungsfunktionalität der in Fig. 8 dargestellten Betriebsstromauswertung 30 (vgl. auch die in Fig. 9 dargestellten Signalverläufe) sei nachfolgend nochmals im Detail erklärt.

### Startbedingung:

Die Flipflops IC11A, IC11B seien zurückgesetzt, so dass deren nicht-invertierende Ausgänge Q jeweils "low"-Pegel und deren invertierende Ausgänge Q-Nicht jeweils "high"-Pegel haben.

Die Eingagssignale Enable und Control2 haben "low"-Pegel. Das Ausgangssignal V2_> hat "low"-Pegel.

### Start der Ablaufsteuerung 20 (Fig 6):

Zu Beginn der Aktivierung der Endstufe 10 (Fig. 3) springt das Eingangssignal Enable auf "high"-Pegel. Dadurch wird das bis dahin über seinen Eingang CLR-Nicht zurückgesetzte Flipflop IC11A freigegeben. Sein nicht-invertierender Ausgang Q liegt auf "low"-Pegel.

Das Signal Control2 betätigt - wie oben beschrieben - den Transistor T1_2, was wiederum durch den Wert des Strommesssignals Isense gesteuert wird.

Für die Betriebsstromauswertung 30 ist nun das wenigstens einmalige Erreichen des oberen Stromwertes von Isense in der Phase relevant, solange der Strom aus der Versorgung V2 (zweite Versorgungsspannung) geliefert wird. Dieses Erreichen wird daran erkannt, dass T1_2 wenigstens einmal ein- und ausgeschaltet wird, bzw. das Signal Control2 wenigstens einmal von "low"-Pegel auf "high"-Pegel und zurück springt.
1. Fall - Der Laststrom durch L1 wird während der Versorgung aus V2 erreicht:
   Um T1_2 zu betätigen, schaltet die Ablaufsteuerung 30 das Signal Control2 auf "high"-Pegel, woraufhin das durch den Inverter IC12A invertierte Signal am Triggereingang CLK von IC11A von "high"- auf "low"-Pegel springt.

Nun steigt der Strom durch L1 an, bis - vermittelt über den Wert von Isense - der obere Abschaltpunkt erreicht wird und das Signal Control2 auf "low"-Pegel springt.

Der Inverter IC12A wandelt dies in einen Sprung auf "high"-Pegel um, was das Flipflop IC 11A triggert, so dass sein Ausgang Q den "high"-Pegel des Dateneingangs D übernimmt. Dieser Zustand bleibt für den Rest der Aktivierungsphase der Endstufe erhalten.

Zum Ende der Endstufenaktivierungsphase springt das Signal Enable auf "low"-Pegel. Der Inverter IC12B invertiert dieses Signal, so dass das Flipflop IC11B über seinen Triggereingang CLK getriggert wird. Dadurch übernimmt der Ausgang Q von IC11B den Pegel von IC11A, Ausgang Q und das Signal V2_> nimmt "high"-Pegel an.

Anmerkung: Da das Signal Enable am Ende der Aktivierungsphase "low"-Pegel annimmt, wird das Flipflop IC11A zurückgesetzt, so dass sein nicht-invertierender Ausgang Q "low"-Pegel annimmt. Sollte dies nun geschehen, bevor das Flipflop IC11B den zuvor anliegenden (gültigen) "high"-Pegel übernommen hat, so kann dies mit einem Verzögerungsglied zwischen IC11A, Ausgang Q und IC11B, Eingang D behoben werden. Die benötigte Verzögerungszeit (z. B. typisch <100ns) hängt von den konkret verwendeten Schaltungskomponenten ab. Ein Verzögerungsglied kann z. B. mit einem Tiefpass bestehend aus einem Serienwiderstand und einem Parallelkondensator aufgebaut werden.
2. Fall - Der Laststrom durch L1 wird während der Versorgung aus V2 nicht erreicht:
   Auch hier wird T1_2 eingeschaltet, indem das Signal Control2 "high"-Pegel annimmt. Der Inverter IC12A schaltet den Triggereingang von IC11A entsprechend auf "low"-Pegel, jedoch bleibt dies für die gesamte Aktivierungsphase der Fall. IC11A wird also nicht getriggert und sein Ausgang Q bleibt auf "low"-Pegel.

Zum Ende der Aktivierungsphase wird IC11B über das invertierte Enable-Signal getriggert und übernimmt nun an seinem nicht-invertierenden Ausgang Q den "low"-Pegel von IC11A. Das Signal V2_> springt somit auf "low"-Pegel und bleibt dort solange, bis der 1. Fall erfolgreich durchlaufen wird.

Dadurch ist sichergestellt, dass bei Nicherreichen des oberen Abschaltpunktes der Strommessung V2_> dauerhaft "low"-Pegel annimmt und in der Folge davon V2 solange erhöht wird (unten noch beschrieben), bis dieser Zustand behoben ist.

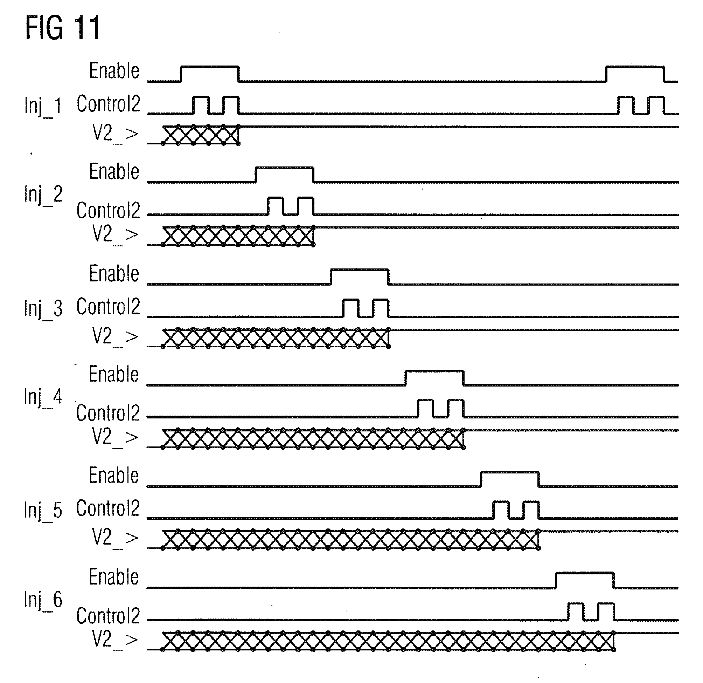

Wie es oben bereits erwähnt wurde, werden im Falle eines Systems mit mehreren induktiven Lasten mehrere Ablaufsteuerungen wie z. B. die dargestellte Ablaufsteuerung 30 benötigt. Da dieser Spezialfall insbesondere für eine Anwendung der Erfindung bei einer Einspritzanlage eines Kraftfahrzeugs relevant ist, sei nachfolgend zunächst die entsprechende schaltungstechnische Erweiterung am Beispiel eines Systems mit 6 Einspritzventilen und 6 Ablaufsteuerungen (samt jeweiliger Betriebsstromauswertung) anhand der Fig. 10 und 11 verdeutlicht.

Fig. 11 zeigt in einer gemeinsamen Zeitverlaufsdarstellung die Signale Enable und Control2 für 6 Ablaufsteuerungen der in Fig. 6 dargestellten Art und das Signal V2_> für 6 jeweils zugehörige Betriebsstromauswertungen der in Fig. 8 dargestellten Art; für 6 verschiedene Kraftstoffinjektoren (symbolisiert durch die Bezeichnungen Inj_1, Inj_2, ... Inj_6), die entsprechend einer Einspritzfolge der betreffenden Brennkraftmaschine für jeweilige Kraftstoffeinspritzungen zeitversetzt anzusteuern sind. Dementsprechend sind die in Fig. 11 dargestellten Signalverläufe zeitlich zueinander versetzt.

In Fig. 10 sind die sechs Ablaufsteuerungen mit Ablfst_11, Ablfst_12, ... Ablfst_16 bezeichnet. Die jeweiligen Ausgangssignale V2_> dieser Ablaufsteuerungen werden, wie in Fig. 10 dargestellt, in einem UND-Gatter IC21 zusammengefasst als ein Signal Ref_Control. Dieses Signal Ref_Control besitzt "high"-Pegel, solange die entsprechenden induktiven Lasten (Magnetventile der Injektoren) die obere Stromgrenze im intermittierenden Betrieb der zweiten Betriebsphase erreichen. Erreicht jedoch wenigstens eine Last nicht die obere Stromgrenze bzw. den gewünschten Laststrom, so springt das Signal Ref_Control auf den "low"-Pegel. Der "low"-Pegel wird solange beibehalten bis alle Lasten wieder ordnungsgemäß die obere Stromgrenze erreicht haben.

Die in Fig. 10 dargestellte Verknüpfungsschaltung 32 ist optional. Sie wird nur für den Fall der Ansteuerung mehrerer Lasten benötigt. Das von der Verknüpfungsschaltung 32 ausgegebene Indikatorsignal Ref_Control ist gewissermaßen das Analogon zu dem Indikatorsignal V2_> der Betriebsstromauswertung für eine einzelne Last.

Die Betriebsstromauswertung 30 (Fig. 8), gegebenenfalls eine Mehrzahl solcher Schaltungsteile samt einer Verknüpfungsschaltung wie der in Fig. 10 dargestellten, bildet Überwachungsmittel zum Überwachen der Erreichung des gewünschten Laststromes während der zweiten Betriebsphase. Das Ergebnis dieser Überwachung wird durch das Signal V2_> einer einzelnen Betriebsstromauswertung 30 bzw. das Verknüpfungssignal Ref_Control der Verknüpfungsschaltung angegeben.

Auf Basis dieses Überwachungsergebnisses wird gemäß der Erfindung schließlich eine nachfolgend beschriebene Anpassung der zweiten Betriebsspannung V2 vorgenommen. Die nachfolgende Beschreibung bezieht sich hierbei, lediglich beispielhaft, auf den Fall des Betriebs mehrerer induktiven Lasten und dementsprechend den Fall der Verwendung des Signals Ref_Control zur bedarfsgerechten Einstellung von V2.

Im beschriebenen Ausführungsbeispiel wird mit dem Signal Ref_Control eine in Fig. 12 ersichtliche bipolare Stromquelle 40 gesteuert, genauer gesagt zwischen zwei Betriebsmodi umgeschaltet. In einem ersten Betriebsmodus liefert die Stromquelle 40 einen positiven Strom an einem Schaltungsknoten K4, wohingegen die Stromquelle 40 in ihrem zweiten Betriebsmodus einen negativen Strom am Schaltungsknoten K4 liefert. Der Pegel des Eingangssignals Ref_Control bestimmt hierbei den Betriebsmodus. Der aus Fig. 12 ersichtliche Aufbau der Stromquelle 40 ist von an sich bekannter Art und bedarf daher keiner näheren Erläuterung. Erwähnenswert ist, dass der im ersten Betriebsmodus von der Stromquelle 40 gelieferte positive Strom im dargestellten Beispiel wesentlich größer als der im Falle des zweiten Betriebsmodus gelieferte negative Strom ist. Dies wird bei der dargestellten Schaltung durch entsprechend unterschiedliche Werte der Widerstände R31 und R32 erreicht.

Der Ausgang der Stromquelle 40 (Schaltungsknoten K4) ist mit einer Integrationsstufe 42 umfassend einen Kondensator C31 verbunden, der den mittleren Strom der geschalteten Stromquelle 40 integriert. Der Kondensator C31 ist mit einem Versorgungspotenzial (+5 V) verbunden, so dass beim Start ein Ausgang der Stromquelleneinrichtung 40, 42 ein Ausgangssignal Vref mit dem Wert dieses Versorgungspotenzials (hier: +5V) liefert. Der Schaltungsknoten K4 der Stromquelleneinrichtung ist über einen Widerstand R33 mit einem Mittelabgriff eines Spannungsteilers R34, R35 verbunden, der im Betrieb der Anordnung eine aus der 5 V-Versorgung abgeleitete Referenzspannung Vref erzeugt. Der Widerstand R33 begrenzt den Verstellbereich für die Referenzspannung Vref durch die Stromquelle 40.

Hat Ref_Control den "low"-Pegel, so schaltet die Stromquelle 40 auf positiven Strom (von der 5 V-Versorgung kommend) und Vref steigt. Hat Ref_Control jedoch "high"-Pegel, so schaltet die Stromquelle 40 auf negativen Strom (nach Masse) und Vref sinkt.

Die von der bipolaren Stromquelleneinrichtung 40, 42 erzeugte Referenzspannung Vref dient nun dazu, die von der Endstufe 10 (Fig. 3) verwendete zweite Betriebsspannung V2 zu regeln. Steigt Vref, so steigt auch der Wert von V2. Sinkt Vref, so wird auch V2 sinken. Diese gemäß des Ausführungsbeispiels vorgesehene Regelungscharakteristik ist beispielhaft anhand entsprechender Signalverläufe in Fig. 13 dargestellt. In dieser Figur sind außerdem die oberen und unteren Grenzen für den Verstellbereich der Referenzspannung Vref eingezeichnet und mit Vrefmax und Vrefmin bezeichnet.

Fig. 14 ist ein Prinzipschaltbild eines DC/DC-Wandlers 50 zur Erzeugung der zweiten Betriebsspannung V2 aus einer Basisspannung (Bordnetzspannung Vbat (hier z. B. 12 V-Batteriespannung)). Der Wandler 50 ist in dargestellter Weise als ein Schaltregler aufgebaut. Kernstück des Schaltreglers ist ein Steuerungsbaustein, bei welchem es sich im dargestellten Ausführungsbeispiel um einen unter der Modellbezeichnung "SG 2524" kommerziell erhältlichen Baustein der Fa. Texas Instruments handelt. Dieser Baustein enthält einen Anschluss 54 zur Eingabe einer Spannungsreferenz Vref (die von der bipolaren Stromquelleneinrichtung von Fig. 12 geliefert wird), einen Fehlerverstärker 56, einen Regler 58, einen Sägezahngenerator 60, einen Komparator 62, sowie weitere, hier der Einfachheit halber nicht eingezeichnete Funktionsgruppen.

Der Fehlerverstärker 56 erfasst die Abweichung zwischen Vref und einer Spannung am Mittelabgriff eines Spannungsteilers R41, R42. Letztere Abgriffspannung ist repräsentativ für den Wert der Ausgangsspannung V2. Der nachgeschaltete Regelverstärker 58 erzeugt daraus eine Gleichspannung, die im Komparator 62 mit der Sägezahnspannung des Sägezahngenerators 60 verglichen wird. So entsteht am Ausgang des Komparators 62 ein Signal konstanter Frequenz mit variablem Tastverhältnis, welches einen Schaltregler-Transistor T41 steuert. Wird T41 eingeschaltet, so wird eine Spule L41 aus der Batteriespannung Vbat bestromt. Wird T41 ausgeschaltet, so fließt der Spulenstrom von L41 über eine Diode D41 in einen Kondensator C42 und liefert somit die Energie für die Bereitstellung der zweiten Versorgungsspannung V2. Dadurch wird am Ausgangsanschluss des Wandlers 50 (Spannung V2) die vom Verbraucher entnommene Energie nachgeliefert. Ein Kondensator C41 puffert die Versorgungsspannung Vbat. Regelziel ist, dass die Abgriffspannung am Spannungsteiler R41, R42 den gleichen Wert wie die eingegebene Referenzspannung Vref besitzt, wodurch auch V2 auf einen Wert in Abhängigkeit von Vref stabilisiert wird (V2 ist proportional zu Vref). Der Aufbau des dargestellten Schaltreglers 50 ist selbstverständlich nur beispielhaft zu verstehen und könnte in der Praxis dementsprechend auch modifiziert sein.

Bei dem beschriebenen Ausführungsbeispiel umfasst die erfindungsgemäße Schaltungsanordnung zum Betrieb von mehreren Einspritzventilen also:
- die Endstufe 10 (Fig. 3), wobei für jedes Einspritzventil (induktive Last L1) eine an sich bekannte mehrfache Parallelanordnung von Transistoren T2 vorgesehen ist (T1 wird für alle Einspritzventile verwendet),
- mehrere Ablaufsteuerungen 20 (Fig. 6),
- mehrere Betriebsstromauswertungen 30 (Fig. 8),
- die Verknüpfungsschaltung 32 (Fig. 10),
- die bipolare Stromquelleneinrichtung 40, 42 (Fig. 12), und
- den gesteuerten DC/DC-Wandler 50 (Fig. 14).

Das Anpassungsverhalten der erfindungsgemäßen Schaltungsanordnung kann wie folgt beschrieben werden: Ausgelöst durch die Betriebsstromauswertung 30 (Fig. 8), und mittels der Verknüpfungsschaltung 32 (Fig. 10) verknüpft, wird Vref durch die Stromquelleneinrichtung 40, 42 (Fig. 12) derart gesteuert, dass die zweite Betriebsspannung V2 einen Wert annimmt, der gerade eben zum Erreichen der oberen Betriebsstromgrenze (und somit des gewünschten Laststromes) für sämtliche induktiven Lasten L1 (Einspritzventile) benötigt wird.

Die Regelung führt dabei eine Totzeitschwingung aus. Startend von einer hohen (sicheren) zweiten Betriebsspannung V2, sinkt diese Spannung V2 langsam solange ab, bis eine der induktiven Lasten L1 die obere Betriebsstromgrenze nicht mehr erreicht. Bedingt durch die unterschiedlichen Stromwerte der bipolaren Stromquelle 40 für deren positiven und negativen Strom steigt in diesem Fall die zweite Betriebsspannung V2 relativ schnell an, bis alle induktiven Lasten im weiteren Betrieb wieder die obere Betriebsstromgrenze erreichen. Daraufhin sinkt V2 abermals langsam ab und der Anpassungszyklus beginnt erneut.

Die maximal mögliche Spannung von V2 (definiert durch die obere Begrenzung Vrefmax der Referenzspannungssteuerung) kann wegen der dynamischen Regelung ohne Nachteile höher gewählt werden, als es für einen sicheren Betrieb der Lasten im Normalfall erforderlich wäre (V2 hat im Normalbetrieb stets die minimal mögliche Spannung). Durch eine solche Erhöhung des Maximalwerts von V2 wird auch bei einer Last mit einem grenzwertig hohem bzw. geringfügig zu hohem Widerstand der gewünschte Betriebsstrom eingehalten. Dies erweitert auch den Nutzungsbereich der betreffenden Last.

Bei der erfindungsgemäßen Schaltungsanordnung ist es außerdem problemlos möglich, einen unzulässigen Widerstandsanstieg im Strompfad der Last dadurch zu erfassen, dass die angepasste zweite Betriebsspannung V2 überwacht wird, insbesondere z. B. gemessen und mit einem hierfür vorgesehenen Sollbereich (oberer und/oder unterer Grenzwert) verglichen wird. Ein Ansprechen einer solchen Grenzwerterkennung kann z. B. zur frühzeitigen Warnung für einen sich abzeichnenden Ausfall eines Kraftstoffinjektors herangezogen werden, wenn der obere Grenzwert etwas unterhalb der maximal möglichen Spannung von V2 liegt.

Alternativ oder zusätzlich ist es möglich, den aktuellen Wert von V2 zu bestimmen und mit einem vorgegebenen Sollwert zu vergleichen. Dieser Sollwert kann für die Anwendung der Erfindung bei einer Einspritzanlage z. B. zunächst von einem Startwert gebildet sein (z. B. gewünschter Soll-Betriebsstrom multipliziert mit einem nominellen Widerstandswert im Lastpfad). Hierbei können auch weitere Einflussgrößen berücksichtigt werden, wie z. B. wenigstens eine Temperatur (z. B. Injektortemperatur, abgeleitet aus der Öltemperatur des Motors), Vorhaltewerte für Injektor- und Zuleitungswiderstände etc.

Eine wesentliche Abweichung des Istwerts von V2 von dem vorgegebenen, insbesondere z. B. berechneten Sollwert kann dann zum Erkennen eines übermäßigen bzw. unzulässigen Widerstandsanstieges im Laststrompfad verwendet werden. Dies erlaubt eine verfeinerte, dynamische Überwachung des Lastwiderstandes.

Zusammenfassend wird mit der erfindungsgemäßen Anpassung der zweiten Betriebsspannung V2 das sichere Erreichen des Betriebsstromes in allen Injektoren gewährleistet. Insbesondere können sich folgende Vorzüge ergeben:
- Die zweite Betriebsspannung V2 wird auf einen vergleichsweise kleinen Wert geregelt, der zum Erreichen des gewünschten Laststromes in allen Injektoren erforderlich ist.
- Etwaige Zuschläge für Widerstandsänderungen, Fertigungstoleranzen etc. können weitestgehend reduziert werden.
- Durch den im Nominalfall geringeren Spannungswert von V2 verbessert sich der Wirkungsgrad desjenigen DC/DC-Wandlers, welcher diese Betriebsspannung erzeugt.
- Auch sinkt die Eingangsstromwelligkeit, so dass etwaige EMV-Filtermaßnahmen weniger aufwändig ausgeführt werden können.
- Die Verlustleistung der Schalttransistoren in der Endstufe wird wesentlich reduziert.
- Durch die verringerte Verlustleistung kann wiederum das Entwärmungskonzept der betreffenden Einrichtung (z. B. Motorsteuergerät in einem Kraftfahrzeug) vereinfacht werden.
- Die EMV-Abstrahlung reduziert sich durch die niedrigere PWM-Spannung und -Frequenz.
- Das Gesamtsystem kann fehlertoleranter ausgestaltet werden. Lässt man einen erhöhten Maximalwert für die Regelung von V2 zu, so kann auch bei unzulässig erhöhtem Gesamtwiderstand im Strompfad der Last der gewünschte Betriebsstrom noch erreicht werden.
- Fügt man außerdem noch eine Überspannungserkennung von V2 hinzu, so kann bei einer schleichenden Widerstandserhöhung (z. B. Kontaktkorrosion) ein sich abzeichnender Ausfall rechtzeitig erkannt und behoben werden. Dies vermeidet im Automobilbereich ein Liegenbleiben des Fahrzeugs auf Grund eines Versagens der Kraftstoffeinspritzung.

Bei der beschriebenen Schaltungsanordnung bzw. dem damit realisierten Betriebsverfahren können wie bereits erwähnt folgende Besonderheiten vorgesehen werden:
- Erfassung eines oberen Abschaltpunktes des Laststromes beim PWM-Betrieb (zweite Betriebsphase) der Last/Lasten.
- Speicherung des Ereignisses, bei welchem der jeweilige Laststrom den oberen Abschaltpunkt erreicht hat.
- Logische Verknüpfung der Speicherergebnisse für sämtliche einer Mehrzahl von betriebenen Lasten.
- Verwendung eines Verknüpfungssignals (für mehrere Lasten) zur Steuerung einer Referenzspannung eines DC/DC-Wandlers zur Erzeugung der zweiten Betriebsspannung.
- Begrenzung des Steuerungsbereiches für die Referenzspannung.
- Vergleichsweise schneller Anstieg der Referenzspannung (und damit von V2), wenn eine oder mehrere Lasten den oberen Abschaltpunkt des Laststromes nicht erreichen; vergleichsweise langsames Absinken der Referenzspannung (und damit von V2), solange die Last bzw. sämtliche Lasten den oberen Abschaltpunkt des Laststromes erreichen.
- Messung bzw. Speicherung des Werts von V2 abhängig von äußeren Einflussgrößen (z. B. Öltemperatur eines Motors).
- Feststellung einer relevanten Abweichung von V2 relativ zu den gespeicherten Werten.
- Erkennen eines sich abzeichnenden Ausfalls, bedingt durch einen unzulässig hohen Gesamtwiderstand im Strompfad der Last/Lasten.

## Patentansprüche

1. Schaltungsanordnung zum Betreiben einer induktiven Last (L1), insbesondere eines Magnetventils eines Kraftstoffeinspritzsystems einer Brennkraftmaschine, umfassend
- Bestromungsmittel (10) zum Bestromen der Last (L1), die dazu ausgebildet sind, während einer ersten Betriebsphase eine erste Betriebsspannung (V+) an der Last anzulegen und während einer darauffolgenden zweiten Betriebsphase eine zweite Betriebsspannung (V2), die kleiner als die erste Betriebsspannung (V+) ist, in intermittierender Weise an der Last (L1) anzulegen,
- Einstellmittel (20) zum Steuern des intermittierenden Betriebs der Bestromungsmittel (10) während der zweiten Betriebsphase zur Einstellung eines gewünschten Laststromes (IL) durch geeignetes Einschalten und Ausschalten der zweiten Betriebsspannung (V2) an der Last (L2), und
- Überwachungsmittel (30, 32) zum Überwachen der Erreichung des gewünschten Laststromes (IL) während der zweiten Betriebsphase,
**gekennzeichnet durch**
Anpassungsmittel (40, 42, 50) zum Anpassen der zweiten Betriebsspannung (V2) basierend auf dem Ergebnis der Überwachung.

2. Schaltungsanordnung nach Anspruch 1, wobei die Bestromungsmittel (10) eine Schalttransistoranordnung (T1_2) zum Einschalten und Ausschalten der zweiten Betriebsspannung (V2) an der Last (L1) umfassen.

3. Schaltungsanordnung nach einem der vorangehenden Ansprüche, wobei während der zweiten Betriebsphase ein PWM-Betrieb der Bestromungsmittel (10) vorgesehen ist und die Einstellmittel (20) ein PWM-Tastverhältnis zur Einstellung des gewünschten Laststromes (IL) variieren.

4. Schaltungsanordnung nach einem der vorangehenden Ansprüche, wobei die Einstellmittel (20) eine Zweipunktregelung derart vorsehen, dass die zweite Betriebsspannung (V2) ausgeschaltet wird, sobald der Laststrom (IL) eine obere Stromgrenze erreicht und die zweite Betriebsspannung (V2) wieder eingeschaltet wird, sobald der Laststrom (IL) eine untere Stromgrenze erreicht.

5. Schaltungsanordnung nach einem der vorangehenden Ansprüche, wobei die Überwachungsmittel (30, 32) die Erreichung des gewünschten Laststromes (IL) durch eine Erfassung wenigstens eines damit einhergehenden Ausschaltens der zweiten Betriebsspannung (V2) während der zweiten Betriebsphase feststellen.

6. Schaltungsanordnung nach einem der vorangehenden Ansprüche, wobei die Anpassungsmittel (30, 32) eine ständige Veränderung der zweiten Betriebsspannung (V2) bewirken, wobei von den Überwachungsmitteln (30, 32) das Vorzeichen der Veränderung vorgegeben wird.

7. Schaltungsanordnung nach einem der vorangehenden Ansprüche, wobei weitere Überwachungsmittel zum Überwachen der zweiten Betriebsspannung (V2) im Hinblick auf die Überschreitung einer oberen Spannungsgrenze vorgesehen sind.

8. Verfahren zum Betreiben einer induktiven Last (L1), insbesondere eines Magnetventils eines Kraftstoffeinspritzsystems einer Brennkraftmaschine, umfassend
- eine Bestromung der Last (L1) derart, dass während einer ersten Betriebsphase eine erste Betriebsspannung (V+) an die Last (L1) angelegt wird und während einer darauffolgenden zweiten Betriebsphase eine zweite Betriebsspannung (V2), die kleiner als die erste Betriebsspannung (V+) ist, in intermittierender Weise an die Last (L1) angelegt wird,
- eine Steuerung des intermittierenden Betriebs der Bestromungsmittel während der zweiten Betriebsphase zur Einstellung eines gewünschten Laststromes (IL) durch geeignetes Einschalten und Ausschalten der zweiten Betriebsspannung (V2) an der Last (L1), und
- eine Überwachung der Erreichung des gewünschten Laststromes (IL) während der zweiten Betriebsphase,
**gekennzeichnet durch**
eine Anpassung der zweiten Betriebsspannung (V2) basierend auf dem Ergebnis der Überwachung.

## Claims

1. Circuit arrangement for operating an inductive load (L1), in particular a magnetic valve of a fuel injection system of an internal combustion engine, comprising
- energizing means (10) for energizing the load (L1), which are designed so as to apply a first operating voltage (V+) at the load during a first operating phase and to apply a second operating voltage (V2), which is smaller than the first operating voltage (V+), in intermittent fashion at the load (L1) during a subsequent second operating phase,
- setting means (20) for controlling the intermittent operation of the energizing means (10) during the second operating phase in order to set a desired load current (IL) by suitably switching on and switching off the second operating voltage (V2) at the load (L2), and
- monitoring means (30, 32) for monitoring the attainment of the desired load current (IL) during the second operating phase,
**characterised by**
adjustment means (40, 42, 50) for adjusting the second operating voltage (V2) on the basis of the result of the monitoring.

2. Circuit arrangement as claimed in claim 1, wherein the energizing means (10) comprise a switching transistor arrangement (T1_2) for switching on and switching off the second operating voltage (V2) at the load (L1).

3. Circuit arrangement as claimed in one of the preceding claims, wherein during the second operating phase PWM operation of the energizing means (10) is provided and the setting means (20) vary a PWM duty cycle in order to set the desired load current (IL).

4. Circuit arrangement as claimed in one of the preceding claims, wherein the setting means (20) provide an on-off control in such a manner that the second operating voltage (V2) is switched off as soon as the load current (IL) attains an upper current limit and the second operating voltage (V2) is switched on again as soon as the load current (IL) attains a lower current limit.

5. Circuit arrangement as claimed in one of the preceding claims, wherein the monitoring means (30, 32) determine the attainment of the desired load current (IL) by sensing at least one accompanying switch-off of the second operating voltage (V2) during the second operating phase.

6. Circuit arrangement as claimed in one of the preceding claims, wherein the adjustment means (30, 32) bring about a constant change in the second operating voltage (V2), wherein the sign of the change is predefined by the monitoring means (30, 32).

7. Circuit arrangement as claimed in one of the preceding claims, wherein further monitoring means are provided for monitoring the second operating voltage (V2) with regard to exceeding an upper voltage limit.

8. Method for operating an inductive load (L1), in particular a magnetic valve of a fuel injection system of an internal combustion engine, comprising
- energization of the load (L1) in such a manner that a first operating voltage (V+) is applied to the load (L1) during a first operating phase and a second operating voltage (V2), which is smaller than the first operating voltage (V+), is applied in intermittent fashion to the load (L1) during a subsequent second operating phase,
- control of the intermittent operation of the energizing means during the second operating phase in order to set a desired load current (IL) by suitably switching on and switching off the second operating voltage (V2) at the load (L1), and
- monitoring the attainment of the desired load current (IL) during the second operating phase, and
**characterised by**
adjustment of the second operating voltage (V2) on the basis of the result of the monitoring.

## Revendications

1. Agencement de circuit pour faire fonctionner une charge inductive (L1), en particulier une vanne magnétique d'un système d'injection de carburant d'un moteur à combustion interne comprenant
- des moyens d'alimentation en courant (10) pour alimenter la charge (L1), ces moyens étant agencés de telle façon qu'au cours d'une première phase de fonctionnement, ils appliquent une première tension de fonctionnement (V+) à la charge et qu'au cours d'une deuxième phase successive de fonctionnement, ils appliquent d'une manière intermittente à la charge (L1), une deuxième tension de fonctionnement (V2) inférieure à la première tension de fonctionnement (V+),
- des moyens de réglage (20) pour commander le fonctionnement intermittent des moyens d'alimentation en courant (10) au cours de la deuxième phase de fonctionnement afin d'établir un courant de charge (IL) souhaité par une application appropriée de la deuxième tension de fonctionnement (V2) à la charge (L2) et une coupure appropriée de celle-ci, et
- des moyens de surveillance (30, 32) pour surveiller le moment auquel le courant de charge (IL) souhaité est atteint au cours de la deuxième phase de fonctionnement,
**caractérisé par** des moyens d'adaptation (40, 42, 50) pour adapter la deuxième tension de fonctionnement (V2) en se basant sur le résultat de la surveillance.

2. Agencement de circuit selon la revendication 1, dans lequel les moyens d'alimentation en courant (10) comprennent un agencement de transistors de commutation (T1_2) pour appliquer la deuxième tension de fonctionnement (V2) à la charge (L1) et pour la couper de celle-ci.

3. Agencement de circuit selon l'une des revendications précédentes, dans lequel, au cours de la deuxième phase de fonctionnement, il est prévu un fonctionnement à modulation de largeurs d'impulsions des moyens d'alimentation en courant (10) et les moyens de réglage (20) font varier un rapport cyclique de type à modulation par largeurs d'impulsions afin de régler le courant de charge (IL) souhaité.

4. Agencement de circuit selon l'une des revendications précédentes, dans lequel les moyens de réglage (20) assurent un réglage à deux points de telle façon que la deuxième tension de fonctionnement (V2) soit coupée dès que le courant de charge (IL) atteint une limite de courant supérieure et que la deuxième tension de fonctionnement (V2) soit de nouveau appliquée dès que le courant de charge (IL) atteint une limite inférieure de courant.

5. Agencement de circuit selon l'une des revendications précédentes, dans lequel les moyens de surveillance (30, 32) constatent le moment auquel le courant de charge souhaité est atteint en détectant au moins une coupure qui l'accompagne de la deuxième tension de fonctionnement (V2) au cours de la deuxième phase de fonctionnement.

6. Agencement de circuit selon l'une des revendications précédentes, dans lequel les moyens d'adaptation (30, 32) provoquent un changement permanent de la deuxième tension de fonctionnement (V2), les moyens de surveillance (30, 32) prescrivant le signe du changement.

7. Agencement de circuit selon l'une des revendications précédentes, dans lequel il est prévu d'autres moyens de surveillance pour surveiller la deuxième tension de fonctionnement (V2) concernant le dépassement d'une limite supérieure de tension.

8. Procédé pour faire fonctionner une charge inductive (L1), en particulier une vanne magnétique d'un système d'injection de carburant d'un moteur à combustion interne consistant à
- alimenter la charge (L1), de telle façon qu'au cours d'une première phase de fonctionnement, une première tension de fonctionnement (V+) soit appliquée à la charge et qu'au cours d'une deuxième phase successive de fonctionnement, une deuxième tension de fonctionnement (V2) inférieure à la première tension de fonctionnement (V+) soit appliquée d'une manière intermittente à la charge (L1),
- commander le fonctionnement intermittent des moyens d'alimentation en courant au cours de la deuxième phase de fonctionnement afin d'établir un courant de charge (IL) souhaité par une application appropriée de la deuxième tension de fonctionnement (V2) à la charge (L2) et une coupure appropriée de cette tension de la charge, et
- surveiller le moment auquel le courant de charge (IL) souhaité est atteint au cours de la deuxième phase de fonctionnement,
**caractérisé par** une adaptation de la deuxième tension de fonctionnement (V2) en se basant sur le résultat de la surveillance.
